# EUROPÄISCHE PATENTSCHRIFT

(11) **EP 2 302 516 B1**
(45) Veröffentlichungstag und Bekanntmachung des Hinweises auf die Patenterteilung: **18.07.2012**
(21) Anmeldenummer: 10015461.6
(22) Anmeldetag: 13.05.2008
(51) Int. Cl.: G06F 9/48, G06F 17/50

(54) **Verfahren zur Ausführung von Tasks zur Berechnung eines zu simulierenden Signals in Echtzeit**
Method to perform tasks for calculating a signal to be simulated in real time
Procédé d'exécution de tâches destinée au calcul d'un signal devant être simulé en temps réel

(43) Veröffentlichungstag der Anmeldung: 30.03.2011
(62) Teilanmeldung aus: 08008827.1
(73) Patentinhaber: dspace digital signal processing and control engineering GmbH, 33102 Paderborn (DE)
(72) Erfinder: Müller, Björn, 59557 Lippstadt (DE); Krügel, Karsten, Dr., 33098 Paderborn (DE); Klahold, Jürgen, 33034 Brakel (DE)
(74) Vertreter: Cohausz Hannig Borkowski Wißgott

(56) Entgegenhaltungen:
- ING-RAY CHEN: "ON APPLYING IMPRECISE COMPUTATION TO REAL-TIME AI SYSTEMS", COMPUTER JOURNAL, OXFORD UNIVERSITY PRESS, SURREY, GB, Bd. 38, Nr. 6, 1. Januar 1995 (1995-01-01) , Seiten 434-442, XP000580407, ISSN: 0010-4620
- LUI SHA: "Dependable system upgrade", REAL-TIME SYSTEMS SYMPOSIUM, 1998. PROCEEDINGS. THE 19TH IEEE MADRID, SPAIN 2-4 DEC. 1998, LOS ALAMITOS, CA, USA,IEEE COMPUT. SOC, US, 2. Dezember 1998 (1998-12-02), Seiten 440-448, XP010318773, ISBN: 978-0-8186-9212-3
- BUTTAZZO ET AL: "Hard Real-Time Computing Systems: Predictable Scheduling Algorithms and Applications (Second Edition), Handling overload conditions", REAL-TIME SYSTEMS SERIES, SPRINGER, Bd. 23, 1. Oktober 2004 (2004-10-01), Seiten 233-279, XP002475695, ISBN: 978-0-387-23137-2

## Beschreibung

Die Erfindung betrifft ein Verfahren zur Ausführung wenigstens eines Tasks zur Berechnung wenigstens eines zu simulierenden Signals in Echtzeit mittels eines auf einer Datenverarbeitungsanlage mit einem Echtzeitbetriebssystem in Software implementierten Taskmanagers, der periodisch jeweils nach einer vorgegebenen vorgebbaren Periodendauer einen Task startet, welcher aus wenigstens einem vorgegebenen Eingangssignal wenigstens ein davon abhängiges Ausgangssignal berechnet und auf der Datenverarbeitungsanlage eine Menge von wenigstens zwei verschiedenen Tasks mit unterschiedlichen Berechnungszeiten zur Berechnung desselben wenigstens einen zu simulierenden Signals ausführbar gespeichert sind und wenigstens ein Minimaltask eine Berechnungszeit kürzer als die Periodendauer aufweist, wobei der Taskmanager wenigstens einen der Tasks aus der Menge nach einer gespeicherten Strategie startet, mit welcher unter Einhaltung der Echtzeit innerhalb der gegebenen Periodendauer ein Berechnungsergebnis wenigstens eines der Tasks aus der Menge erhalten wird.

Ein solches Verfahren ist z.B. aus der Veröffentlichung ING-RAY CHEN: "ON APPLYING IMPRECISE COMPUTATION TO REAL-TIME AI SYSTEMS", COMPUTER JOURNAL, OXFORD UNIVERSITY PRESS, SURREWY, GB, Bd. 38, Nr. 6, 1. Januar 1995 (1995-01-01), Seiten 434-442, XP 000580407, ISSN: 0010-4620 bekannt.

Weiterbin benennt die Veröffentlichung LUI SHA: "Dependable systems upgrade", REAL-TIME SYSTEMS SYMPOSIUM , 1998. PROCEEDINGS. THE 19TH IEEE MADRID, SPAIN 2-4- DEC. 1998, LOS ALAMITOS, CA, USA, IEEE COMPUT. SOC, US, 2. Dezember 1998 (1998-12-02), Seiten 440-448, XP 010318773, ISBN: 978-0-8186-9212-3 es als bekannt, parallel arbeitende Controller zum Zweck der Fehlerreduktion durch Redundanz einzusetzen.

Im Stand der Technik ist es bekannt, Sachverhalte der realen Welt technisch mittels Datenverarbeitungsanlagen zu simulieren. Dabei wird insbesondere zum Test von technischen Komponenten, wie beispielsweise Steuergeräten, insbesondere Kraftfahrzeugsteuergeräten, bevorzugt, eine Echtzeitsimulation durchzuführen, d.h. eine Simulation, bei der ein außen stehender Betrachter die durch die Simulation erzeugten Ereignisse so wahrnimmt, als würden sie tatsächlich in realer Zeit geschehen.

Bei der Echtzeitsimulation kann es durch zu komplexe Modelle zu Problemen bezüglich der Berechnungszeit bzw. der Güte der durchgeführten Berechnungen kommen. Dementsprechend kann es vorkommen, dass beim Einsatz zu komplexer Modelle Probleme auftreten, beispielsweise also, dass die Einhaltung der Echtzeit während einer Simulation nicht gewährleistet werden kann unter gleichzeitiger Erzielung korrekter Berechnungsergebnisse.

Beispielsweise können solche Probleme entstehen durch die Verwendung von anderen Modellen als den bekannten Mittelwertmodellen in der Motorsimulation. In der Regel wird heutzutage zur Simulation im automotiven Umfeld das Euler-Verfahren mit einer festen Schrittweite zur numerischen Approximation von physikalischen Systemen benutzt. Dabei stellt es sich für einen Ingenieur als schwierig dar, eine Schrittweite aufzufinden, die zum einen die numerische Stabilität des Gesamtsystems gewährleistet und zum anderen die Echtzeitfähigkeit des Systems zu keiner Zeit gefährdet. So kann es demnach vorkommen, dass zu komplexe Modelle programmiert werden, die eine zu große Berechnungszeit benötigen und somit das Simulationsergebnis nicht in Echtzeit liefern können. Hierbei wird bei der hier beschriebenen Erfindung unter dem Begriff der Komplexität von durchzuführenden Berechnungstasks verstanden, dass mit steigender Komplexität die Berechnungszeit eines Tasks steigt. Ein Task ist dabei eine Berechnungsvorschrift, um aus Eingangssignalen davon abhängige Ausgangssignale zu berechnen. Insgesamt kann somit der Wunsch nach einer höheren Komplexität oder aber die Notwendigkeit nach einer höheren Komplexität die Echtzeitfähigkeit der dafür vorzunehmenden Berechnungen gefährden.

Im Stand der Technik ist es somit bekannt, wie eingangs genannt, einen Task zur Berechnung eines zu simulierenden Signals durchzuführen, wobei es bekanntermaßen vorgesehen sein kann, einen in Software implementierten Taskmanager zu verwenden, der periodisch jeweils nach einer vorgegebenen vorgebbaren Periodendauer einen solchen Task startet.

Dabei sind bisherige Programmierungen derart vorgenommen worden, dass ein zu startender Task garantiert innerhalb der vorgegebenen Periodendauer seine Berechnung abschließt, um die Echtzeitfähigkeit nicht zu gefährden. Hier kann es in Einzelfällen vorkommen, dass der Abschluss der Berechnung die zur Verfügung stehende Rechenzeit innerhalb einer vorgegebenen Periodendauer nicht ausschöpft, beispielsweise da der ausgeführte Task zu bestimmten Zeitpunkten oder bei bestimmten gegebenen Umständen schneller als erwartet gerechnet werden konnte. Es zeigt sich somit, dass in einer solchen Situation ein genauerer Task hätte berechnet werden können, als es tatsächlich durchgeführt wurde. Die Rechenkapazitäten der simulierenden Datenverarbeitungsanlage werden demnach ersichtlich nicht ausgeschöpft, um immer auf der sicheren Seite der Echtzeitfähigkeit zu bleiben.

Im Stand der Technik ist es dabei weiterhin bekannt, zur Erzielung einer möglichst hohen Genauigkeit unter gleichzeitiger Beibehaltung der Echtzeitfähigkeit, vor der Durchführung einer Simulation zu entscheiden, ob ein gewünschter Sachverhalt mit einem einfach modulierten Modell, also beispielsweise einem Task mit geringer Rechenzeit oder mit einem komplex formulierten Modell, somit also einem Task mit höherer Berechnungszeit, berechnet wird.

Ein Nachteil dieser Lösung liegt darin, dass immer vor der Simulation bereits festgelegt werden muss, mit welcher Komplexität eine Rechnung durchgeführt werden soll. Die Entscheidung, einen komplexen Task mit höherer Rechenzeit auszuwählen, ist dabei jedoch problembehaftet, da nicht immer im Vorfeld, d.h. vor der tatsächlichen Durchführung der Simulation, einwandfrei entschieden werden kann, ob die Möglichkeit besteht, den komplexformulierten Task tatsächlich unter Einhaltung der Echtzeit bei der konkret gegebenen Bedingung zu berechnen.

Im Stand der Technik ist ein Programm mit der Bezeichnung Mosilab des Fraunhofer-Institutes bekannt, welches ebenfalls versucht, diese Problematik zu lösen, wobei vor jeder Berechnung einer Task entschieden wird, ob ein Sachverhalt mit einem komplexen oder einfachen Task gerechnet werden soll. So ist es in Verbindung mit der Mosilab-Software bekannt, zwischen interessanten Zuständen eines Systems, z.B. die sich durch die Berechung vorangegangener Tasks oder Entscheidungen vor der Simulation ergeben und weniger interessanten Zuständen eines Systems zu unterscheiden und hiervon abhängig die Berechnung von einfachen oder komplexen Tasks vor der Simulation auszuwählen. Beispielsweise bei der Simulation der Arbeitsweise einer Solaranlage kann vor der Simulation von deren Verhalten bei Nacht entschieden werden, Rechenaufwand einzusparen. Weiterhin kann zwar vor einer Task entschieden werden, ob eine einfache oder komplexe Task berechnet werden soll, jedoch kann nicht immer vorher abgeschätzt werden, ob eine komplexe Task in Echtzeit berechnet werden kann. Somit ist auch die Mosilab-Software nicht geeignet, während der Durchführung einer Echtzeitsimulation Einfluss zu nehmen auf die zu berechnenden Tasks und deren Komplexität bzw. die damit einhergehende Rechenzeit.

Aufgabe der Erfindung ist es, ein Verfahren der eingangs genannten Art bereitzustellen, welches die Möglichkeit schafft, während der Laufzeit einer Simulation die Einhaltung der Echtzeit zu garantieren und dabei gleichzeitig alle Möglichkeiten ausschöpft, um möglichst genaue Simulationsergebnisse bei der Berechnung zu erzielen. Dabei kann die Ausführung der eingangs genannten Tasks sowohl für vollständige Modelle eines zu simulierenden Signals oder aber auch eines Teilmodells zur Simulation eines Signals vorgesehen sein. Die Nachteile des Standes der Technik, nach dem immer nur ein Task berechnet wird, der garantiert innerhalb der vorgegebenen Periodendauer zum Abschluss der Berechnung führt, sollen behoben werden. Außerdem soll flexibel und ohne Aufwand seitens des Nutzers auf technische Rahmenbedingungen reagiert werden. So soll z.B. berücksichtigt werden, dass auf einem schnellen Prozessor ggf. komplexere Task in Echtzeit berechnet werden können, als auf einem langsameren Prozessor.

Die Aufgabe wird erfindungsgemäß dadurch gelöst, dass die Datenverarbeitungsanlage mehrere parallel arbeitende Prozessoren aufweist und der Taskmanager den Minimaltask und wenigstens einen weiteren Task aus der Menge von wenigstens zwei verschiedenen Tasks mit unterschiedlicher Berechnungsdauer parallel auf je einem der Prozessoren startet, wobei nach Ablauf der Periodendauer das Berechnungsergebnis von demjenigen der parallelen Tasks als Simulationsergebnis übernommen wird, der von den vollständig ausgeführten Tasks wenigstens eines der nachfolgenden Entscheidungskriterien erfüllt: höchste Berechnungsdauer, höchste Berechnungsgenauigkeit, geringste Simulations-Schrittweite.

Die Erwähnung, dass der Taskmanager periodisch einen Task startet schließt dabei nicht aus, insbesondere sogar erfindungsgemäß ein, dass gemäß den nachfolgend beschriebenen Strategien Tasks durch den Taskmanager auch aperiodisch gestartet werden können.

Unter einem zu simulierenden Signal wir dabei jede mögliche physikalische Größe verstanden, die durch ein Berechnungsergebnis eines Task repräsentiert werden kann, wie z.B. elektrische, optische oder akustische Signale, bei elektrischen Signalen insbesondere analoge oder digitale Signale, wie z.B. Spannungen oder Ströme. Solche Signale können z.B. durch Zahlenwerte repräsentiert werden, die aus den Berechnungen einer genannten Task resultieren. Es kann dabei insbesondere auch vorgesehen sein, dass aus den Berechnungsergebnissen der Simulation tatsächliche physikalische Signale gebildet werden, z.B. durch Digital-Analog-Wandlung, Ansteuerung von Stellantrieben etc.

Es ist somit der wesentliche Kerngedanke der Erfindung, ein zu simulierendes Signal nicht nur mit einer einzigen Komplexität und damit verbundener Berechnungszeit in einem Task, sondern dieses Signal in verschiedenen Modellen unterschiedlicher Komplexität und damit einhergehender unterschiedlicher Rechenzeit zu modellieren. Es besteht demnach erfindungsgemäß die Möglichkeit, anhand der gespeicherten Strategie aus den in der Menge unterschiedlicher Komplexität bzw. Berechnungszeit vorliegenden Tasks einen oder mehrere zur Berechnung auszuwählen und so immer innerhalb der vorgegebenen Periodendauer ein Berechnungsergebnis von wenigstens einem der Tasks zu erhalten. Um dabei die Simulation in Echtzeit in jedem Fall garantieren zu können, ist es erfindungsgemäß vorgesehen, dass einer der Tasks derart geringe Komplexität bzw. Rechenzeit aufweist, dass dieser Task garantiert immer innerhalb der vorgegebenen Periodendauer ausgeführt werden kann. Dieser Task, der ein Task aus der Menge der insgesamt zur Verfügung stehenden Tasks auf der Datenverarbeitungsanlage ist, wird nachfolgend weiterhin als Minimaltask bezeichnet, um ihn von den übrigen möglichen Tasks unterscheiden zu können.

Die auf der Datenverarbeitungsanlage, insbesondere in dem zur Verfügung gestellten in Software implementierten Taskmanager gespeicherte Strategie kann ebenso in der Software implementiert sein und bestimmt, wie der eingesetzte Taskmanager periodisch jeweils nach Ablaufen der genannten, damit verbundenen Periodendauer einen oder auch mehrere Tasks aus der zur Verfügung stehenden Menge startet. Hierbei ist die Strategie erfindungsgemäß so gewählt und in Software auf der genannten Datenverarbeitungsanlage implementiert, dass wie eingangs genannt, immer ein Berechnungsergebnis in Echtzeit innerhalb der zur Verfügung stehenden Periodendauer erhalten werden kann.

Erfindungsgemäß ist es vorgesehen, dass die Datenverarbeitungsanlage mehrere parallel arbeitende Prozessoren aufweist und der Taskmanager den Minimaltask und wenigstens einen weiteren Task aus der Menge parallel auf je einem der Prozessoren startet, wobei nach Ablauf der Periodendauer das Berechnungsergebnis von demjenigen der parallelen Tasks als Simulationsergebnis übernommen wird, der von den vollständig ausgeführten Tasks die höchste Berechnungsdauer und damit die höchste Genauigkeit des Ergebnisses aufweist.

So wird durch die parallele Abarbeitung in jedem Fall sicher gestellt, dass der Minimaltask ein Berechnungsergebnis liefert, wobei durch die Parallelität der Berechnung eine Chance erhalten wird, innerhalb der zur Verfügung stehenden Periodendauer ebenso auch einen Task in seiner Berechnung zum Abschluss zu bringen, der eine höhere Genauigkeit aufweist als der Minimaltask. Sofern dies der Fall ist, wird demnach gemäß dieser gespeicherten Strategie das Ergebnis des Tasks mit einer höheren Berechnungsdauer, bevorzugt des Tasks mit der höchsten Berechnungsdauer, als Simulationsergebnis übernommen. So kann die Möglichkeit bestehen, dass aus jedem der parallel arbeitenden Prozessoren gegebenenfalls mehrere Berechnungsergebnisse bereit gestellt werden, wobei über die Menge aller berechnenden, erfindungsgemäß demnach das genaueste Berechnungsergebnis, also das mit der höchsten Berechnungsdauer übernommen wird.

Wie eingangs erwährt, wird hier für eine Datenverarbeitungsanlage eine Menge von mehreren Tasks bereit gestellt, die alle für dasselbe zu simulierende Signal ein Simulationsergebnis berechnen können, hierfür jedoch unterschiedliche Rechenzeiten benötigen, wobei zumindest einer der Tasks als Minimaltask ausgeführt ist, der eine garantierte Berechnungszeit aufweist, die geringer ist als die zur Verfügung stehende Periodendauer. Unterschiede bei der Berechnungszeit der einzelnen Tasks können sich z.B. dadurch ergeben, dass die Schrittweite, mit welcher die Tasks Berechnungen durchführen, verschieden gewählt ist. Demnach kann ein Task mit einer höheren Berechnungsdauer eine geringere Schrittweite haben als ein Task mit einer geringeren Berechnungsdauer. Berechnungsdauern können sich ebenso unterscheiden durch die Solver, mit der die Tasks berechnet werden. So hat ein komplexer Task, also einer mit einer höheren Berechnungsdauer, einen ebenso komplexeren Solver als ein Task mit einer geringeren Komplexität. Ein Solver ist ein Algorithmus, der in diesem speziellen Fall die numerische Lösung eines DAE (differential algebraic equation) bzw. einer DGL (Differentialgleichung) berechnet. Bekannte Solver sind z.B. Verfahren nach Euler, Heun, Runga-Kutta.

Weitere Unterschiede in der Berechnungsdauer können sich auch dadurch ergeben, dass die Gleichungen, die innerhalb eines Tasks berechnet werden, verschiedene Genauigkeiten aufweisen, bevorzugt jedoch immer mit der gleichen Anzahl von Zuständen, insbesondere also Eingangsparametern für die Gleichungen. So können für Tasks mit höheren Rechenzeiten demnach genauere Gleichungen verwendet werden.

Weitere Unterschiede in der Berechnungszeit können sich auch dadurch ergeben, dass die Anzahl der zu berechnenden Funktionen oder die Anzahl der für die Berechnung verwendeten Parameter unterschiedlich sind. Ist es in einem hier nicht beschränkend zu verstehenden Beispiel vorgesehen, die Funktion eines Bremsen-Antiblockiersystems zu simulieren, so kann beispielsweise in einem Task mit geringerer Berechnungsdauer lediglich ABS-Funktionen, wie beispielsweise der Bremsdruck und die Raddrehung erfasst werden. In einem Task mit höherer Berechnungsdauer können demgegenüber zusätzliche Funktionen bzw. Parameter zu den vorgenannten, wie beispielsweise Bremsassistentfunktionen mitberücksichtigt werden, wie die Geschwindigkeit, mit der auf das Bremspedal getreten wird und/oder die Geschwindigkeit, mit der das Gaspedal gelöst wird.

In einer mit allen möglichen Ausführungen kombinierbaren Weiterbildung kann es auch vorgesehen sein, die Periodendauer, nach der Task gestartet werden, zu ändern. Eine Umprogrammierung der Periodendauer kann z.B. während der Laufzeit der aktuellen Periodendauer erfolgen, so dass nach deren Ablauf sich folgende geänderte Periodendauern anschließen.

Allgemein kann es auch vorgesehen sein, dass das genannte erfindungsgemäße Verfahren nicht nur für ein einziges zu simulierendes Signal eingesetzt wird, sondern für viele verschiedene Signale, die ggfs. auch parallel berechnet werden.

Das hier vorgestellte erfindungsgemäße Verfahren kann technisch beispielsweise auf verschiedene Arten realisiert sein. Beispielsweise kann es vorgesehen sein, dass das Verfahren auf einer Datenverarbeitungsanlage abläuft, mittels der für ein reales elektronisches Steuergerät, beispielsweise ein Kraftfahrzeugsteuergerät, eine Testumgebung simuliert wird und wobei dem realen Steuergerät Signale und/oder Daten aus der simulierten Steuergeräteumgebung von der Datenverarbeitungsanlage zugeführt werden und das Steuergerät reale Signale und/oder berechnete Daten an die Datenverarbeitungsanlage sendet. So findet hier demnach ein Datenaustausch von realen und simulierten Signalen bzw. Daten zwischen einer Datenverarbeitungsanlage, auf der das erfindungsgemäße Verfahren läuft und einem tatsächlichen realen elektronischen Steuergerät statt. Diese Kommunikation der Signale oder Daten kann dabei beispielsweise leitungsgebunden über elektrische oder optische Signalleitungen oder auch funkgebunden stattfinden. Die entsprechenden Signale können hierbei an den dafür vorgesehenen Ports der jeweiligen Datenverarbeitungsanlage bzw. des elektronischen Steuergerätes zum Versenden zur Verfügung gestellt bzw. empfangen werden.

In einer anderen Alternative kann es auch vorgesehen sein, dass das Verfahren auf einem realen elektronischen Steuergerät, wie beispielsweise einem Kraftfahrzeugsteuergerät, ausgeführt wird, um dessen Steuerverhalten zu simulieren, wobei dem Steuergerät Signale und/oder Daten aus der realen Steuergeräteumgebung zugeführt werden, beispielsweise von Sensoren und Messwertaufnehmern und wobei das Steuergerät simulierte Signale und/oder simuliert berechnete Daten an die Steuergeräteumgebung abgibt, beispielsweise an Aktoren. Auch hier findet demnach eine entsprechende Kommunikation statt, die auf die gleiche Art und Weise vorgenommen werden kann, wie es zu der vorherigen Ausführung genannt ist.

In einer wiederum weiteren Möglichkeit kann es auch vorgesehen sein, dass das Verfahren auf einer Datenverarbeitungsanlage abläuft, mittels der das Steuerverhalten eines Steuergerätes, insbesondere eines Kraftfahrzeugsteuergerätes, simuliert wird, wobei der Datenverarbeitungsanlage Signale und/oder Daten aus der realen Steuergeräteumgebung, insbesondere von Sensoren und Messwertaufnehmern zugeführt werden oder aber auch hier eine Simulation vorgesehen ist, also beispielsweise von einer Datenverarbeitungsanlage zur Simulation einer Steuergeräteumgebung zugeführt werden und von der das Steuerverhalten simulierenden Datenverarbeitungsanlage simulierte Signale und/oder Daten an die reale oder simulierte Steuergeräteumgebung zugeführt werden. Es findet demnach auch hier wieder eine Kommunikation von Signalen und Daten in beiden Richtungen statt, wobei die an dieser Kommunikation teilhabenden Geräte entweder real sein können oder ihrerseits simuliert sind.

Es besteht so zusammengefasst die Möglichkeit, mit dem erfindungsgemäßen Verfahren in verschiedenen technischen Anwendungen die Echtzeitfähigkeit von Simulationen unter Erzielung möglichst genauer Berechnungsergebnisse bereit zu stellen.

Ausführungsbeispiele der Erfindung sind in den nachfolgenden Figuren dargestellt. Es zeigen:
- Figur 1: eine Variante, bei der ein Simulationsrechner die Umgebung für ein konkretes Steuergerät simuliert
- Figur 2: eine Variante, bei der im Steuergerät selbst die Simulation von dessen Steuerverhalten stattfindet
- Figur 3: das parallele Berechnen von Tasks unterschiedlicher Berechnungszeiten

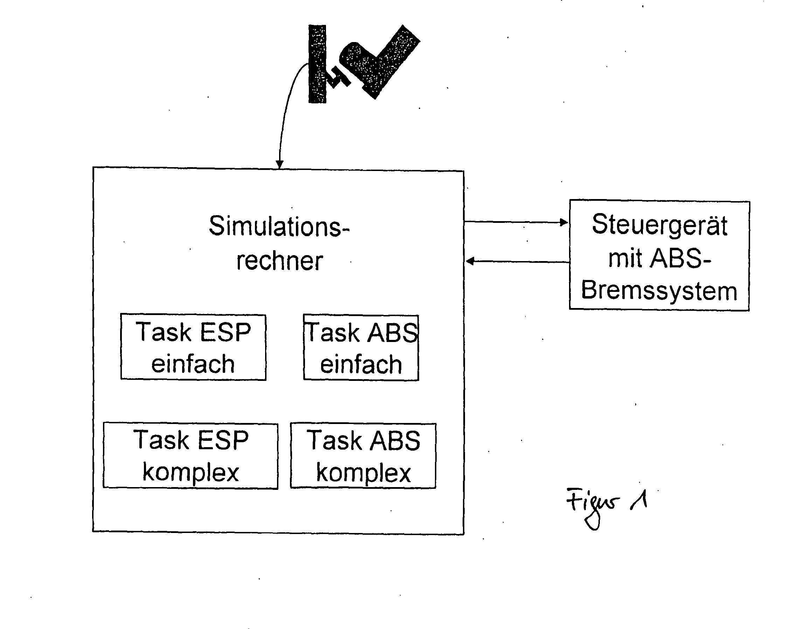

Die Figur 1 zeigt hier exemplarisch eine der möglichen, zuvor genannten Anwendungsmöglichkeiten, bei denen es vorgesehen ist, dass eine Datenverarbeitungsanlage als Simulationsrechner arbeitet und das eingangs beschriebene erfindungsgemäße Verfahren durchführt. Hier ist es vorgesehen, dass der Simulationsrechner eine Umgebung für ein konkretes reales Kraftfahrzeugsteuergerät simuliert. Zwischen dem simulierenden Rechner und dem konkreten Steuergerät findet ein Daten- bzw. Signalaustausch statt, beispielsweise bezüglich Signalen und Daten betreffend Informationen über die Straße, Geschwindigkeit, Radstellung etc. Es kann hier in diesem Beispiel das Verhalten des Steuergerätes hinsichtlich seines Steuerverhaltens in Verbindung mit einem Antiblockierbremssystem getestet werden. Die auf dem Simulationsrechner zur Durchführung des erfindungsgemäßen Verfahrens ablaufende Software und der darin implementierte Taskmanager startet gemäß einer vorgegebenen Strategie die dargestellten Tasks, wobei hier jeweils ein einfacher bzw. ein komplexer Task, d.h. ein solcher mit einer geringen bzw. einer höheren Berechnungszeit, jeweils für das Antiblockiersystem bzw. ein ESP-System zur Kontrolle des Schlupfes beim Anfahren oder Kurvenfahrten vorgesehen ist. Gemäß der gespeicherten Strategie werden die hier in der Menge der Tasks vorgesehenen Tasks parallel berechnet und das Ergebnis der Berechnung an das Steuergerät bereitgestellt, um eine Umgebung, also z.B. das Fahren eines Autos auf einer Straße, dem Steuergerät zu simulieren und dessen Reaktionen auf die simulierte Umgebung in einer Kommunikation zurück zum Simulationsrechner zu erhalten.

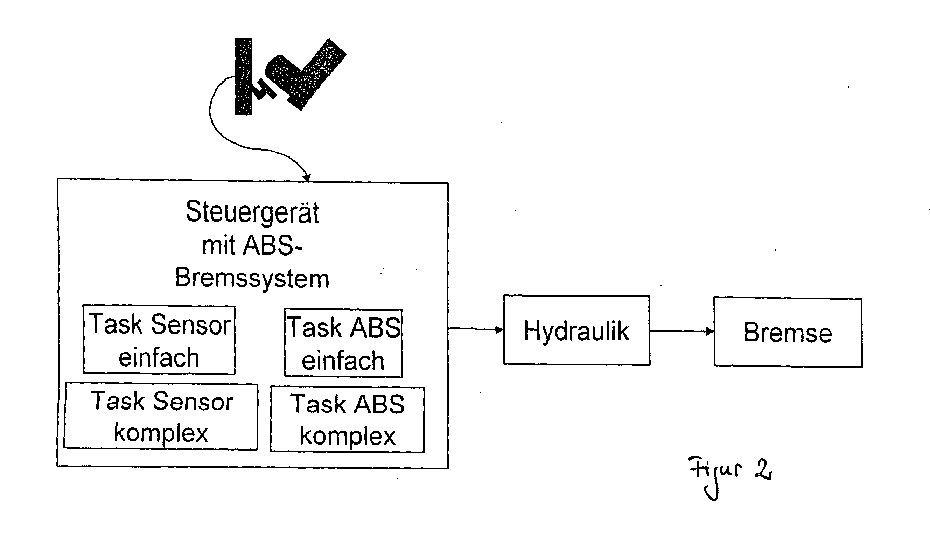

Die Figur 2 zeigt eine alternative Möglichkeit der Anwendung, bei der das Steuergerät selbst das erfindungsgemäße Verfahren durchführt, das Steuergerät also noch nicht hinsichtlich seiner elektronischen Ausgestaltung konkretisiert ist, sondern dessen Steuerverhalten softwareseitig simuliert wird. Auch hier kommt das erfindungsgemäße Verfahren zum Einsatz, wobei hier entsprechende Tasks von geringerer oder höherer Berechnungszeit, gekennzeichnet als "einfach" bzw. "komplex" vorgesehen sind. Nicht dargestellt ist es hier, dass dem Steuergerät zur Simulation seines Steuerverhaltens von außen Signale oder Daten zugeführt werden können, die beispielsweise von einer realen Umgebung stammen, beispielsweise aus einer Kraftfahrzeugumgebung, wobei anhand der so erhaltenen Daten oder Signale das Steuergerät durch Abarbeitung der Task gemäß den erfindungsgemäß möglichen Strategien Ausgangsgrößen zur Verfügung stellt, die unmittelbar die Hydraulik bzw. die Bremse des konkreten Kraftfahrzeugs beeinflussen können. Es ist darauf hinzuweisen, dass die hier dargestellten Anwendungen der Figuren 1 und 2 lediglich exemplarisch zu verstehend sind und keine Beschränkung des Verfahrens auf die hier genannten Anwendungen gegeben sind.

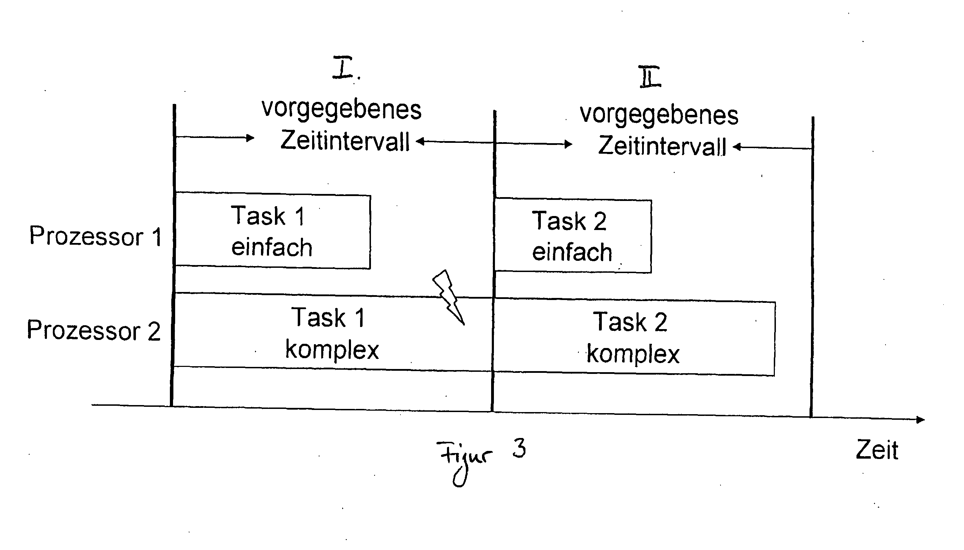

Die Figur 3 zeigt eine Ausführung der parallelen Abarbeitung verschiedener Tasks auf mehreren Prozessoren, hier am Beispiel von lediglich zwei Prozessoren der Datenverarbeitungsanlage, auf welchem das erfindungsgemäße Verfahren durchgeführt wird. Durch den in Software implementierten Taskmanager auf der Datenverarbeitungsanlage werden hier auf jeden der beiden Prozessoren 1 und 2 jeweils ein Task gestartet, wobei es sich auf dem Prozessor 1 um den Minimaltask handelt, der garantiert die Möglichkeit bereitstellt, innerhalb der zur Verfügung stehenden Periodendauer die Berechnung dieses Tasks komplett abzuschließen. In der hier dargestellten zeitlichen Periode I ist ersichtlich, dass zwar der Prozessor 1 die Abarbeitung des Minimaltasks abschließen kann innerhalb der zur Verfügung stehenden Periodendauer, nicht jedoch der Prozessor 2, die Abarbeitung des komplexeren Tasks mit der höheren Berechnungszeit. Demnach wird durch den Taskmanager nach Beendigung der zur Verfügung stehenden Periodendauer die Berechnung des komplexeren Tasks auf den Prozessor 2 abgebrochen und lediglich das Berechnungsergebnis des Minimaltasks verwertet.

Bei der weiteren periodischen Durchführung gemäß des Verfahrens II ist ersichtlich, dass wiederum auf den Prozessor 1 der Minimaltask gestartet wurde, dessen Berechnung auch innerhalb der zur Verfügung stehenden Periodendauer abgeschlossen werden konnte, hier wurde jedoch ebenso auch durch den Prozessor 2 die Berechnung des komplexeren und damit rechenintensiveren Tasks vor dem Ende der Periodendauer beendet. Gemäß der zugrunde liegenden Strategie wählt der Taskmanager demnach das Ergebnis des rechenintensiveren Tasks auf dem Prozessor 2 als Simulationsergebnis.

Es ist ersichtlich, dass das hier dargebotene Beispiel auch noch mit mehreren Prozessoren als den hier dargestellten zwei durchgeführt werden kann und demnach auch mehr als nur zwei Tasks mit unterschiedlichen Berechnungszeiten gleichzeitig gestartet werden können.

## Patentansprüche

1. Verfahren zur Ausführung wenigstens eines Tasks zur Berechnung wenigstens eines zu simulierenden Signals in Echtzeit mittels eines auf einer Datenverarbeitungsanlage mit einem Echtzeitbetriebssystem in Software implementierten Taskmanagers, der periodisch jeweils nach einer vorgegebenen / vorgebbaren Periodendauer einen Task startet, welcher aus wenigstens einem vorgegebenen Eingangssignal wenigstens ein davon abhängiges Ausgangssignal berechnet, und auf der Datenverarbeitungsanlage eine Menge von wenigstens zwei verschiedenen Tasks mit unterschiedlichen Berechnungszeiten zur Berechnung desselben wenigstens einen zu simulierenden Signals ausführbar gespeichert sind und wenigstens ein Minimaltask eine Berechnungszeit kürzer als die Periodendauer aufweist, wobei der Taskmanager wenigstens einen der Tasks aus der Menge nach einer gespeicherten Strategie startet, mit welcher unter Einhaltung der Echtzeit innerhalb der gegebenen Periodendauer ein Berechnungsergebnis wenigstens eines der Tasks aus der Menge erhalten wird, **dadurch gekennzeichnet, dass** die Datenverarbeitungsanlage mehrere parallel arbeitende Prozessoren aufweist und der Taskmanager den Minimaltask und wenigstens einen weiteren Task aus der Menge parallel auf je einem der Prozessoren startet, wobei nach Ablauf der Periodendauer das Berechnungsergebnis von demjenigen der parallelen Tasks als Simulationsergebnis übernommen wird, der von den vollständig ausgeführten Tasks wenigstens eines der nachfolgenden Entscheidungskriterien erfüllt:
a. höchste Berechnungsdauer,
b. höchste Berechnungsgenauigkeit,
c. geringste Simulations-Schrittweite.

2. Verfahren nach Anspruch 1, **dadurch gekennzeichnet, dass** es auf einer Datenverarbeitungsanlage abläuft, mittels der für ein reales elektronisches Steuergerät, insbesondere ein Kraftfahrzeugsteuergerät eine Testumgebung simuliert wird, wobei dem realen Steuergerät Signale und / oder Daten aus der simulierten Steuergeräteumgebung von der Datenverarbeitungsanlage zugeführt werden und das Steuergerät reale Signale und / oder berechnete Daten an die Datenverarbeitungsanlage sendet.

3. Verfahren nach einem der vorherigen Ansprüche, **dadurch gekennzeichnet, dass** es auf einem realen elektronischen Steuergerät, insbesondere einem Kraftfahrzeugsteuergerät ausgeführt wird, zur Simulation von dessen Steuerverhalten, wobei dem Steuergerät Signale und / oder Daten aus der realen Steuergeräteumgebung, insbesondere von Sensoren und Messwertaufnehmern zugeführt werden und das Steuergerät simulierte Signale und / oder simuliert berechnete Daten an Aktoren der realen Steuergeräteumgebung abgibt.

4. Verfahren nach einem der vorherigen Ansprüche, **dadurch gekennzeichnet, dass** es auf einer Datenverarbeitungsanlage abläuft, mittels der das Steuerverhalten eines Steuergerätes, insbesondere eines Kraftfahrzeugsteuergerätes simuliert wird, wobei der Datenverarbeitungsanlage Signale und/oder Daten aus der realen Steuergeräteumgebung, insbesondere von Sensoren und Messwertaufnehmern zugeführt werden oder von einer Datenverarbeitungsanlage zur Simulation einer Steuergeräteumgebung zugeführt werden und von der das Steuerverhalten simulierenden Datenverarbeitungsanlage simulierte Signale und/oder Daten an die reale oder simulierte Steuergeräteumgebung zugeführt werden.

## Claims

1. Method for executing at least one task for the real-time calculation of at least one signal that is to be simulated using a task manager which is implemented on a data processing installation with a real-time operating system in software and which periodically, in each case after a prescribed/prescribable period length, starts a task which takes at least one prescribed input signal and calculates at least one output signal that is dependent thereon, and the data processing installation stores, in executable form, a set of at least two different tasks with different calculation times for the calculation of said at least one signal that is to be simulated, and at least one minimal task has a calculation time shorter than the period length, wherein the task manager starts at least one of the tasks from the set in accordance with a stored strategy which is used to obtain a calculation result for at least one of the tasks from the set within the given period length while observing the real time, **characterized in that** the data processing installation has a plurality of processors operating in parallel, and the task manager starts the minimal task and at least one further task from the set in parallel on each of the processors, wherein, when the period length has elapsed, the calculation result from that of the parallel tasks which, among the completely executed tasks, satisfies at least one of the following decision criteria:
a. longest calculation time,
b. highest calculation precision,
c. shortest simulation step size,
is accepted as simulation result.

2. Method according to Claim 1, **characterized in that** it takes place on a data processing installation which is used to simulate a test environment for a real electronic controller, particularly a motor vehicle controller, wherein the real controller is supplied with signals and/or data from the simulated controller environment by the data processing installation, and the controller sends real signals and/or calculated data to the data processing installation.

3. Method according to one of the preceding claims, **characterized in that** it is carried out on a real electronic controller, particularly a motor vehicle controller, for the purpose of simulating the control behaviour of the latter, wherein the controller is supplied with signals and/or data from the real controller environment, particularly by sensors and measured-value pickups, and the controller outputs simulated signals and/or simulated calculated data to actuators in the real controller environment.

4. Method according to one of the preceding claims, **characterized in that** it takes place on a data processing installation which is used to simulate the control behaviour of a controller, particularly a motor vehicle controller, wherein the data processing installation is supplied with signals and/or data from the real controller environment, particularly by sensors and measured-value pickups, or is supplied with said signals and/or data by a data processing installation for the purpose of simulating a controller environment, and signals and/or data simulated by the data processing installation that simulates the control behaviour are supplied to the real or simulated controller environment.

## Revendications

1. Procédé d'exécution d'au moins une tâche destinée à calculer au moins un signal à simuler en temps réel au moyen d'un gestionnaire de tâches mis en oeuvre sous forme logicielle sur un système de traitement de données comprenant un système d'exploitation en temps réel, lequel gestionnaire lance de manière périodique une tâche respective après une période de temps prédéterminée/pouvant être prédéterminée, laquelle tâche calcule à partir d'au moins un signal d'entrée prédéterminé au moins un signal de sortie dépendant de ce dernier,
et une quantité d'au moins deux tâches différentes ayant des temps de calcul différents est stockée de manière exécutable sur le système de traitement de données pour calculer ledit au moins un signal à simuler, et au moins une tâche minimale présente un temps de calcul inférieur à la période de temps,
dans lequel le gestionnaire de tâches lance au moins l'une des tâches parmi ladite quantité de tâches conformément à une stratégie stockée, à l'aide de laquelle un résultat de calcul d'au moins l'une des tâches, parmi ladite quantité de tâches, est obtenu tout en maintenant le temps réel à une valeur inférieure à la période de temps donnée, **caractérisé en ce que** le système de traitement de données comprend plusieurs processeurs fonctionnant en parallèle et **en ce que** le gestionnaire de tâches lance la tâche minimale et au moins une tâche supplémentaire parmi ladite quantité de tâches en parallèle sur chacun des processeurs, dans lequel, après écoulement de la période de temps, on prend comme résultat de simulation celui des résultats de calcul des tâches parallèles qui satisfait à au moins l'un des critères de décision suivantes :
a. durée de calcul la plus élevée,
b. précision de calcul la plus élevée,
c. taille de pas de simulation la plus faible.

2. Procédé selon la revendication 1, **caractérisé en ce qu'**il est exécuté sur un système de traitement de données au moyen duquel un environnement de test est simulé pour un appareil de commande électronique réel, notamment un appareil de commande de véhicule à moteur, dans lequel des signaux et/ou des données provenant de l'environnement de l'appareil de commande simulé sont fournis à l'appareil de commande réel par le système de traitement de données, et l'appareil de commande envoie des signaux réels et/ou des données calculées réelles au système de traitement de données.

3. Procédé selon l'une quelconque des revendications précédentes, **caractérisé en ce qu'**il est exécuté sur un appareil de commande électronique réel, notamment un appareil de commande de véhicule à moteur, pour simuler son comportement de commande, dans lequel des signaux et/ou des données provenant de l'environnement de l'appareil de commande réel, notamment de capteurs et de transducteurs de mesure, sont fournis à l'appareil de commande, et l'appareil de commande délivre des signaux simulés et/ou des données calculées simulées à des actionneurs de l'environnement de l'appareil de commande réel.

4. Procédé selon l'une quelconque des revendications précédentes, **caractérisé en ce qu'**il est exécuté sur un système de traitement de données au moyen duquel le comportement de commande d'un appareil de commande, notamment d'un appareil de commande de véhicule à moteur, est simulé, dans lequel des signaux et/ou des données provenant de l'environnement de l'appareil de commande réel, notamment de capteurs et de transducteurs de mesure, sont fournis au système de traitement de données ou sont fournis par un système de traitement de données pour simuler un environnement de l'appareil de commande, et des signaux simulés et/ou des données simulées par le système de traitement de données simulant le comportement de commande sont fournis à l'environnement de l'appareil de commande réel ou simulé.
